# EUROPÄISCHE PATENTSCHRIFT

(11) **EP 1 194 815 B1**
(45) Veröffentlichungstag und Bekanntmachung des Hinweises auf die Patenterteilung: **02.06.2004**
(21) Anmeldenummer: 01916912.7
(22) Anmeldetag: 08.03.2001
(51) Int. Cl.: G03F 7/004, C04B 41/88, C04B 41/89, G01K 7/18

(54) **KERAMISCHER GRÜNKÖRPER MIT EINER PLATINHALTIGEN, PHOTOSTRUKTURIERBAREN FUNKTIONSSCHICHT UND VERFAHREN ZU DESSEN HERSTELLUNG**
CERAMIC BLANK WITH A PHOTOSTRUCTURABLE FUNCTIONAL LAYER CONTAINING PLATINUM AND METHOD FOR PRODUCTION THEREOF
EBAUCHE CERAMIQUE COMPORTANT UNE COUCHE FONCTIONNELLE PHOTOSTRUCTURABLE ET CONTENANT DU PLATINE, ET PROCEDE DE PRODUCTION CORRESPONDANT

(30) Priorität: 14.03.2000 DE 10012245
(43) Veröffentlichungstag der Anmeldung: 10.04.2002
(73) Patentinhaber: ROBERT BOSCH GMBH, 70442 Stuttgart (DE)
(72) Erfinder: DE LA PRIETA, Claudio, 70569 Stuttgart (DE); SCHULTE, Thomas, 70376 Stuttgart (DE); GLANZ, Uwe, 71679 Asperg (DE); KUSCHEL, Petra, 71272 Renningen (DE)
(86) Internationale Anmeldenummer: PCT/DE2001/000866
(87) Internationale Veröffentlichungsnummer: WO 2001/069318

(56) Entgegenhaltungen:
- EP-A- 0 569 762
- FR-A- 2 796 718
- DRAUDT R R ET AL: "Photoimageable silver cofireable conductor compatible with 951 Green Tape/sup TM/" 12TH EUROPEAN MICROELECTRONICS AND PACKAGING CONFERENCE. PROCEEDINGS, PROCEEDINGS OF IMAPS-EUROPE '99. 12TH EUROPEAN MICROELECTRONICS AND PACKAGING CONFERENCE, HARROGATE, UK, 7-9 JUNE 1999, Seiten 219-226, XP001011341 1999, Cambridge, UK, Int. Microelectron. & Packaging Soc.-Europe, UK ISBN: 0-9535858-0-8
- MASAKI TAKAKI ET AL: "Photosensitive conductive paste" PROCEEDINGS OF THE 1997 IEEE/CPMT 20TH INTERNATIONAL ELECTRONIC MANUFACTURING SYMPOSIUM;TOKYO, JPN APR 16-18 1997, 1997, Seiten 356-361, XP002170159 Proc IEEE CPMT Int Electron Manuf Technol IEMT Symp;Proceedings of the IEEE/CPMT International Electronic Manufacturing Technology (IEMT) Symposium 1997 IEEE, Piscataway, NJ, USA

## Beschreibung

Die Erfindung betrifft einen keramischen Grünkörper, insbesondere eine keramische Grünfolie, mit einer aufgebrachten photostrukturierbaren, platinhaltigen Funktionsschicht und ein Verfahren zur Herstellung eines derartigen keramischen Grünkörpers nach der Gattung der unabhängigen Ansprüche.

### Stand der Technik

Zur Herstellung von strukturierten Widerstandsschichten oder Leiterbahnen auf keramischen Grünkörpern, die beispielsweise bereichsweise zickzackförmig oder mäanderförmig ausgebildet sind, ist bereits die sog. "Fodel-Technik" bekannt, die von der Firma DuPont entwickelt wurde.

Im einzelnen wird dabei auf keramischen Grünfolien eine Paste aufgedruckt, die anschließend durch Belichtung mit UV-Strahlen und unter Einsatz einer Photomaske strukturiert wird. Nach dieser Strukturierung folgt dann ein Entwickeln der Paste in den belichteten Bereichen. Bei dieser Technik ist jedoch nachteilig, daß stets ein Gelbraum erforderliche ist, da die Pasten empfindlich gegenüber Tageslicht sind. Zudem eignen sich bekannte Pasten auf Grundlage der "Fodel-Technik" nur für Temperaturen von maximal 900°C, d.h. die mit den aufgebrachten und strukturierten Pasten versehenen keramischen Grünfolien dürfen danach bei max. 900°C gebrannt bzw. gesintert werden. Diese Temperaturen sind vielfach jedoch nicht ausreichend. Überdies ist es mit Hilfe der "Fodel-Technik" nicht möglich, gleichzeitig grobe und sehr feine Strukturierungen auf den Grünfolien zu erzeugen. Schließlich eignen sich derartige Pasten nur eingeschränkt zur Erzeugung von platinhaltigen Funktionsschichten und sind vielfach sauerstoffempfindlich.

Darüberhinaus ist weiter bekannt, platinhaltige Pasten auf bereits gebrannte keramische Substrate anstelle von keramischen Grünfolien aufzutragen, und diese dann mittels Photostrukturierung mit strukturierten Funktionsschichten zu versehen. Mit Hilfe dieser Technik ist eine Feinstrukturierung bis zu lateralen Dimensionen von ca. 10 µm möglich, während mittels herkömmlicher Siebdrucktechnik lediglich Strukturen mit lateralen Ausdehnungen oberhalb von 100 µm erzeugbar sind.

In der Anmeldung DE 199 34 109.5 ist vorgeschlagen worden, einen Temperaturfühler herzustellen, bei dem zunächst auf keramischen Grünfolien mäanderförmige Leiterbahnen oder Widerstandsbahnen aus Platin aufgedruckt sind, die danach mit weiteren keramischen Grünfolien in Form eines Mehrlagenhybrids aufgebaut und dann in Cofiring-Technik zu einem Temperaturfühler gesintert werden. Aufgrund der dabei eingesetzten Dickschichttechnik sind jedoch lediglich Leiterbahnbreiten und -abstände von ca. 0,2 mm realisierbar.

Dadurch, daß bekannte platinhaltige photostrukturierbare Funktionsschichten einerseits nur auf bereits gebrannte Keramiken aufgebracht werden können bzw. sich andererseits nur unter erheblichem verfahrenstechnischen Aufwand verarbeiten lassen (Stickstoffatmosphäre, Gelbraum usw.), lassen sie sich zudem nicht in bestehende Fertigungsverfahren integrieren.

In der litauischen Anmeldung LT-97 161 wurde in diesem Zusammenhang bereits eine photostrukturierbare, platinhaltige Paste vorgeschlagen, die sich zum Auftragen auf bereits gebrannten keramischen Folien eignet, und die nach dem Auftragen durch Photostrukturierung zu einer platinhaltigen Funktionsschicht strukturiert werden kann. Damit sind laterale Strukturauflösungen von typischerweise 10 µm - 30 µm erreichbar.

Aufgabe der vorliegenden Erfindung war, ausgehend von der Anmeldung LT-97 161, die darin vorgeschlagene photostrukturierbare Paste derart zu modifizieren, daß sie sich auch zum unmittelbaren Auftrag auf keramische Grünfolien eignet, und damit einen keramischen Grünkörper mit einer ohne größeren verfahrenstechnischen Aufwand verarbeitbaren, photostrukturierbaren platinhaltigen Funktionsschicht zu erzeugen. Gleichzeitig war es Aufgabe der vorliegenden Erfindung, eine deutliche Erhöhung der Strukturauflösung der Funktionsschicht bei gleichzeitiger Beibehaltung der Cofiring-Technologie zur Herstellung von Multilagenstrukturen bzw. Mehrlagenhybriden zu ermöglichen. Auf diese Weise soll eine möglichst einfache Integration in bestehende Produktionslinien gewährleistet werden.

### Vorteile der Erfindung

Der erfindungsgemäße keramische Grünkörper und das erfindungsgemäße Verfahren zur Herstellung eines keramischen Grünkörpers hat gegenüber dem Stand der Technik den Vorteil, daß damit keramische Grünfolien unmittelbar mit photostrukturierbaren, platinhaltigen Funktionsschichten versehen werden können. Diese Funktionsschicht können weiter durch die Photostrukturierung insbesondere in Form von Leiterbahnen oder Widerstandsbahnen strukturiert werden, wobei laterale Auflösungen von weniger als 15 µm, insbesondere zwischen 5 µm und 25 µm, der erzeugten Strukturen der Funktionsschicht erreichbar sind.

Neben einer hohen absoluten lateralen Auflösung der erzeugten Strukturen in den photostrukturierten Funktionsschichten hat der erfindungsgemäße keramische Grünkörper den Vorteil, daß die Photostrukturierung unter Tageslichteinfall und in Gegenwart von Sauerstoff erfolgen kann. Damit ist der keramische Grünkörper und das Verfahren zu dessen Herstellung in einfacher Weise in bestehende Fertigungsprozesse integrierbar und es ergeben sich wesentliche Kostenvorteile gegenüber bekannten, verfahrenstechnisch erheblich aufwendigeren Verfahren.

Vorteilhaft ist weiterhin, daß die nach der Photostrukturierung der Funktionsschicht auf dem keramischen Grünkörper verbleibenden Strukturen nur eine geringe Standardabweichung der lateralen Ausdehnung der erzeugten Strukturen in mindestens einer Dimension von einem vorgegebenen Sollwert aufweisen. Insofern können auch breitere Strukturen als 50 µm erzeugt werden, die dann jedoch beispielsweise eine sehr genau definierte Breite aufweisen. Die Standardabweichung vom Sollwert liegt vorteilhaft unter 10 µm, insbesondere unter 5 µm.

Der erfindungsgemäße keramische Grünkörper eignet sich vorteilhaft zur Erzeugung von Mehrlagenstrukturen auf Keramikbasis, wobei die keramischen Grünkörper mit der aufgebrachten photostrukturierten Funktionsschicht auch zu Hybridbauelementen verarbeitbar sind. Außerdem ist es nun in einfacher Weise möglich, den keramischen Grünkörper vor oder nach dem Aufbringen der Funktionsschicht bereichsweise mit Ausnehmungen und/oder mit Durchkontaktierungen oder oberflächlichen Kontaktflächen zu versehen.

Schließlich erlaubt es der erfindungsgemäße keramische Grünkörper auch, den aus der Anmeldung DE 199 34 109.5 bekannten Temperaturfühler mit verbesserten Eigenschaften hinsichtlich der erzeugten Widerstandsbahnen herzustellen.

Zudem ist die aufgebrachte Funktionsschicht trotz des Zusatzes des katalytisch sehr aktiven Platins zeitlich stabil.

Vorteilhafte Weiterbildungen der Erfindung ergeben sich aus den in den Unteransprüchen genannten Maßnahmen.

So eignet sich als Füllstoff in der auf den keramischen Grünkörper in Form einer Funktionsschicht aufgebrachten Paste anstelle von reinem Platinpulver auch eine Mischung von Platinpulver mit Aluminiumoxidpulver und/oder Zirkoniumdioxidpulver. Diese Mischung führt zu einer Verbesserung der Haftung der erzeugten platinhaltigen Funktionsschicht auf dem grünen keramischen Ausgangskörper bzw. der grünen keramischen Ausgangsfolie ("Greentape") und/oder sie dient, beispielsweise durch Mischung von Platin und Aluminiumoxid-Pulverpartikeln, der Erhöhung des elektrischen Widerstandes der nach der Photostrukturierung aus der Funktionsschicht herausstrukturierten Leiterbahnen.

Weiter ist vorteilhaft, daß die auf den grünen keramischen Ausgangskörper aufgebrachte photostrukturierbare Paste durch eine wäßrige Lösung entwickelt werden kann.

Insgesamt ergibt sich somit eine wesentlich verbesserte Auflösung der erzeugten Strukturen der Funktionsschicht, wobei gleichzeitig die nach dem Abschluß des Sinterns der Grünkörper erhaltenen gebrannten keramischen Substrate beispielsweise Widerstandsbahnen in Mäanderstruktur aufweisen, die gegenüber vergleichbaren Widerstandsbahnen, die über herkömmliche Dickschichttechnik erzeugt worden sind, Widerstandssteigerungen von mehr als 400 % zeigen. Derartige Widerstandsleiterbahnen bedeuten beim Einsatz in Temperatursensoren oder Heizelementen einen deutlich kleineren Flächenbedarf bei gleichzeitig besserer Genauigkeit der Temperaturmessung und höheren Meßwiderstand, d. h. einer besseren Genauigkeit der Meßspannungsauswertung.

Aufgrund der erhöhten Auflösung beim Photostrukturieren der Funktionsschicht ergeben sich zudem deutlich verringerte Schwankungen in den Widerständen der erzeugten Widerstandsleiterbahnen, so daß insgesamt eine höhere Fertigungsqualität, weniger Ausschuß und geringere Abweichungen der erzielten Widerstände von einem vorgegebenen Sollwert erzielt werden.

### Zeichnungen

Die Erfindung wird anhand der Zeichnungen und in der nachfolgenden Beschreibung näher erläutert.

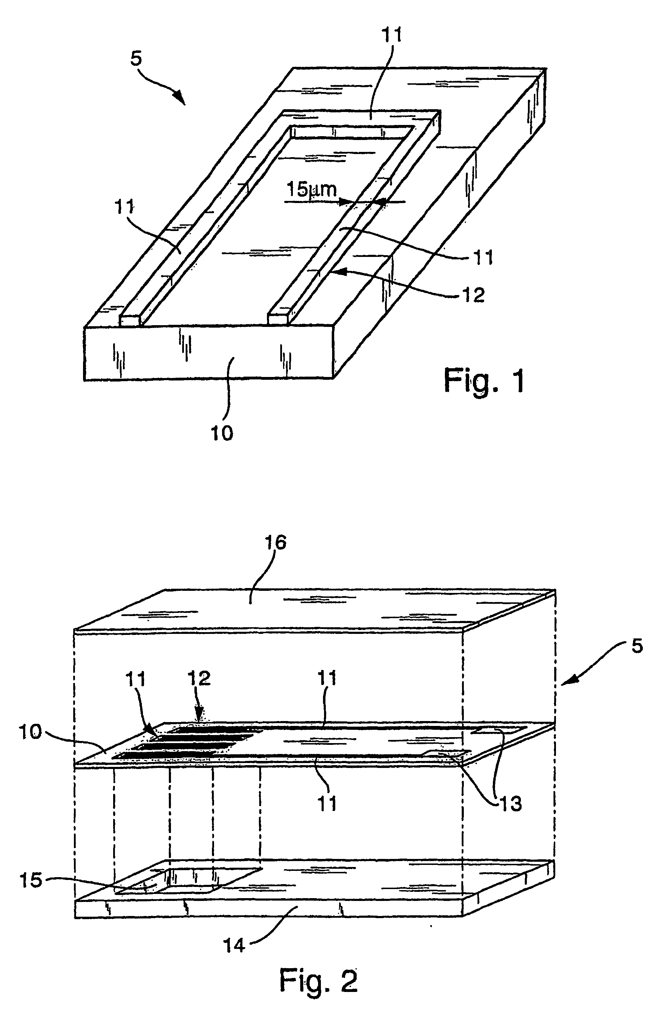

Die Figur 1 zeigt eine Prinzipskizze eines Ausschnittes eines keramischen Grünkörpers mit einer aufgebrachten, photostrukturierten Funktionsschicht. Die Figur 2 zeigt einen Temperaturfühler in Explosionsdarstellung mit einem keramischen Grünkörper mit einer photostrukturierten, platinhaltigen Funktionsschicht in Form von Widerstandsleiterbahnen vor dem Sintern.

### Ausführungsbeipiele

Die Erfindung geht zunächst von einer photostrukturierbaren Paste aus, wie sie in ähnlicher Form bereits aus der Anmeldung LT-97 161 bekannt ist. Die dort beschriebene Paste ist jedoch lediglich zum Auftragen auf bereits gebrannten keramischen Substraten geeignet und muß zum Auftrag auf keramische Grünfolien zunächst modifiziert werden. Diese Modifikation beruht im wesentlichen darauf, daß bei der aus LT-97 161 bekannten Pastenzusammensetzung die dort erforderlichen Glasbestandteile in Form von Glaspulverteilchen entfernt bzw. beim Zusammenmischen der Paste nicht zugesetzt werden.

So wurde überraschend festgestellt, daß sich die aus LT-97 161 bekannte photosensitive bzw. photostrukturierbare Paste zum unmittelbaren Auftragen auf keramischen Grünkörpern dann eignet, wenn man die dort beschriebene Pastenzusammensetzung dahingehend modifiziert, daß die Glaspulverbestandteile nicht zugegeben werden. Weiter wurde festgestellt, daß eine derart modifizierte photosensitive Paste unmittelbar das Erzeugen von strukturierten Funktionsschichten auf keramischen Grünfolien erlaubt, wobei die laterale Ausdehnung der in diesen Funktionsschichten durch die Photostrukturierung erzeugten Strukturen zumindest in einer Dimension, beispielsweise in der Breite, unter 50 µm, insbesondere zwischen 5 µm und 25 µm, liegen. Gleichzeitig wurde festgestellt, daß selbst dann, wenn man breitere Strukturen erzeugen möchte, diese mit deutlich erhöhter Genauigkeit hergestellt werden können. Ein Maß für diese Genauigkeit ist die Standardabweichung der lateralen Ausdehnung der erzeugten Strukturen in mindestens einer Dimension von einem vorgegebenen Sollwert. Diese Standardabweichung liegt typischerweise unter 10 µm, insbesondere unter 5 µm.

Als Füllstoff für die eingesetzte photostrukturierbare Paste, die nach dem Auftrag auf der keramischen Grünfolie die photostrukturierbare Funktionsschicht bildet, eignet sich besonders ein Platinpulver mit einer mittleren Teilchengröße von 10 nm bis 20 µm, insbesondere von 50 nm bis 2 µm. Weiter beträgt die spezifische Oberfläche des anorganischen Füllstoffes bzw. des Platinpulvers in der Paste bevorzugt 0,5 m²/g bis 20 m²/g.

Insgesamt liegt der Gewichtsanteil des anorganischen Füllstoffes in der photostrukturierbaren Paste zwischen 30% bis 90% bezogen auf das Gesamtgewicht der Paste. Bevorzugt ist ein Gewichtsanteil von 50% - 60%.

Besonders bevorzugt ist der Zusatz eines Gemisches von Platinpulver mit einem keramischen Pulver als anorganischer Füllstoff in der photostrukturierbaren Paste. Dazu weist auch das keramische Pulver eine zu dem Platinpulver vergleichbare mittlere Teilchengröße bzw. spezifische Oberfläche von 10 nm bis 20 µm bzw. 0,5 m²/g bis 20 m²/g auf. Als keramisches Pulver werden insbesondere Aluminiumoxid-Pulver, Zirkoniumdioxid-Pulver, Yttrium-stabilisierte Zirkoniumdioxid-Pulver, Yttriumoxid-Pulver, Titandioxid-Pulver, Siliziumoxid-Pulver oder eine Mischung dieser Pulver eingesetzt. Daneben können als Füllstoff jedoch auch platinummantelte, nichtleitende Keramikteilchen eingesetzt werden. Durch den Zusatz des keramischen Pulvers zu dem Platinpulver ergeben sich bei der Herstellung von Widerstandsleiterbahnen bzw. deren Herausstrukturierung aus der Funktionsschicht mit Hilfe der photostrukturierbaren Paste deutlich höhere Flächenwiderstände. Hinsichtlich näherer Details zu diesem prinzipiell bekannten Sachverhalt sei auf die Anmeldung DE 199 34 109.5 verwiesen.

Neben dem Zusatz von reinem Platin als Füllstoff kommt prinzipiell auch der Zusatz von Platinverbindungen, insbesondere Platinprecursorverbindungen wie Platin(II)acetylacetonat, Platin(II)diamin-cyclobatan-1,1-dicarboxylat, Platin(0)-1,3-divinyl-1,1,3,3-tetramethyldisiloxan oder Platin(II)tetraammin-nitrat in Frage. Diese Füllstoffe sind jedoch aus Kostengründen nicht bevorzugt. Zudem können anstelle des keramischen Pulvers auch keramische Precursormaterialien, insbesondere organische Precursormaterialien auf Basis von Si, Al, Zr, Ti und Y eingesetzt werden. Derartige Precursormaterialien sind dem Fachmann bekannt.

Bei den keramischen Grünkörpern bzw. keramischen Folien, auf die die photostrukturierbare Paste als Funktionsschicht aufgebracht, insbesondere aufgedruckt wird, handelt es sich um übliche keramische Grünfolien mit in einer Polymermatrix eingebetteten Keramikpartikeln, beispielsweise Yttriumstabilisierten Zirkoniumdioxidpartikeln oder Aluminiumoxidpartikeln.

Zudem kann auch vorgesehen sein, daß vor dem Aufbringen der photostrukturierbaren Paste als photostrukturierbare Funktionsschicht auf den keramischen Grünkörpern auf diesen zunächst in bekannter Weise eine Zwischenschicht aufgebracht wird. Diese Zwischenschicht ist beispielsweise eine Al₂O₃-Schicht oder TiO₂-Schicht.

Nach dem Aufbringen der photostrukturierbaren Paste auf die keramische Grünfolie in Form einer platinhaltigen Funktionsschicht und deren Photostrukturierung durch bereichsweises Belichten mit Hilfe einer Photomaske wird die Funktionsschicht dann entwickelt und abschließend dann in den unbelichteten Bereichen wieder entfernt. Auf diese Weise verbleibt die Funktionsschicht somit nur in den belichteten Bereichen und es ergibt sich die gewünschte, durch die Photomaske definierte Strukturierung der Funktionsschicht. Danach kann die Weiterverarbeitung des derart erzeugten keramischen Grünkörpers beispielsweise zu Mehrlagenhybridbauteilen oder dem aus der Anmeldung DE 199 34 109.5 bekannten Temperaturfühler erfolgen.

Insgesamt ist es somit mit der im nachfolgenden näher beschriebenen photostrukturierbaren Paste möglich, strukturierte Funktionsschichten auf keramischen Grünfolien zu erzeugen, die unempfindlich gegen das sichtbare Spektrum des Lichtes und die inhibitierende Wirkung von Sauerstoff sind, und die sich durch eine große Photopolymerisationsgeschwindigkeit und eine ausgezeichnete Linienauflösung auszeichnen. Zudem läßt sich die eingesetzte Paste mit Hilfe der bekannten Dickschichttechnologie verarbeiten.

Besonders wichtig für die Paste ist das in den organischen Binder eingesetzte Polymer. Dieses Polymer muß ein photochemisch aktives Polymer sein, d.h. es hat nicht nur die Rolle einer schichtbildenden und die Lösungsfähigkeit vermittelnden Komponente in den Binder, sondern soll gleichzeitig die Photopolymerisation effektiv durch den gegenüber dem sichtbaren Spektrum des Lichtes unempfindlichen Initiator initiieren. Dazu ist es als großmolekulares, polyfunktionales Monomer ausgebildet. Gleichzeitig neutralisieren die Seitenketten des Polymers mit deren Allylgruppen und das zusätzlich in den organischen Binder eingesetzte organische Disulfid die inhibitierende Wirkung von Sauerstoff. Auf diese Weise ist gewährleistet, daß alle technologischen Operationen, d.h. die Vorbereitung des lichtempfindlichen organischen Binders, dessen Vermischung mit dem Füllstoff, das Auftragen der erhaltenen Paste als Funktionsschicht auf die keramische Grünfolie, das nachfolgende Trocknen, Photostrukturieren und Entwickeln unter Tageslicht oder bei gewöhnlicher künstlicher Beleuchtung ausgeführt werden können. Zudem benötigt man keine speziellen Vorkehrungen, um den Kontakt der photostrukturierbaren Funktionsschicht mit dem in der Luft vorhandenen Sauerstoff zu vermeiden.

Beim Vorgang der Polymerisation bilden die linienartigen Makromoleküle des in den Binder der Paste eingesetzten Polymers, die Seitenketten mit Alkyl- und Allylgruppen aufweisen, eine dichte räumliche Struktur, so daß das Polymer im Bereich der belichteten Stellen vollkommen unlösbar in Lösungsmitteln auf Wasserbasis wird. Durch den zugesetzten Photoinitiator aus der Klasse der Azylphosphine ergibt sich im übrigen eine besonders kurze Belichtungszeit.
Insgesamt weist die photostrukturierbare Paste folgende Zusammensetzung in Massenanteilen bezogen auf die Masse des anorganischen Füllstoffes auf:

| | |
|---|---|
| Füllstoff | 100,00 |
| Polymer | 9,00 bis 36,00 |
| Photoinitiator | 0,50 bis 3,50 |
| organisches Disulfid | 0,20 bis 2,00 |
| Inhibitor der thermischen Polymerisation | 0,01 bis 0,35 |
| organisches Lösungsmittel | 5,50 bis 21,50 |

An das im organischen Binder enthaltene Polymer wird eine Reihe von Anforderungen gestellt. So soll es zunächst in wasserlöslichen Basislösungen löslich sein, ein nichthaftendes Häutchen bzw. eine Membran bei Zimmertemperatur bilden, die Viskosität der photostrukturierbaren Paste einstellbar machen und aktiv an der photoinitiierenden, Radikalen-Polymerisation in sauerstoffhaltiger Umgebung teilnehmen. Schließlich soll die thermische Spaltung des Polymers auch bei möglichst niedrigen Temperaturen erfolgen.

Diese Anforderungen werden am besten von Acryl- oder VinylMonomeren und ungesättigten Carbonsäure-Copolymeren erfüllt, wobei deren Molekülmasse bevorzugt zwischen 10.000 und 20.000 liegt und die Masse der ungesättigten Carbonsäure im Copolymer zwischen 15 und 30 Masse% beträgt. Hinsichtlich weiterer Details an die Anforderungen und die Möglichkeiten für die verschiedenen einsetzbaren Polymere sei auf die Anmeldung LT- 97-161 verwiesen.

Da die verwendbaren Polymere Seitenketten mit Acryl- und Allylgruppen besitzen, verringern sie die Empfindlichkeit des organischen Binders gegen die inhibitorische Sauerstoffwirkung deutlich, eliminieren sie jedoch nicht vollständig. Daher ist es weiter erforderlich, ein organisches Disulfid zuzusetzen, dessen allgemeine Formel R₁-CH₂-S-S-CH₂-R₂ für gleiche oder verschiedene Alkyl-, Cycloalkyl-, Aryl-, Arylalkyl- oder Carboxylalkyl-Radikale. Besonders geeignet ist als organisches Disulfid Didodecyl-disulfid.

Als Photoinitiator wird der photostrukturierbaren Paste ein Photoinitiator aus der Acylphosphinklasse zugesetzt. Bevorzugt ist die Verbindung 2,6-Dimethoxybenzoyldiphenyl-Phosphin.

Das zur Einstellung der Viskosität der photostrukturierbaren Paste zugesetzte Lösungsmittel soll zunächst alle organischen Komponenten sehr gut auflösen, gleichzeitig bei Zimmertemperatur wenig flüchtig sein und sich relativ schnell bei Temperaturen von 80°C - 100°C verflüchtigen, da derartige Temperaturen typischerweise beim Trocknen von keramischen Grünfolien insbesondere nach dem Auftragen der photostrukturierbaren Paste in Form der Funktionsschicht eingesetzt werden.

Bevorzugt sind als Lösungsmittel Terpene, Karbitolacetat, Butylkarbitolacetat oder höhere Alkoholester. Besonders bevorzugt ist Benzylalkohol. Um während des Trocknungsvorgangs die Stabilität der Funktionsschicht sicherzustellen, ist es zudem erforderlich, der Paste einen Inhibitor für eine thermische Polymerisation zuzusetzen. Als besonders geeigneter Inhibitor hat sich die Verbindung 2,6-di-tert-Butyl-1,4-Kresol erwiesen.

Die Verarbeitung der einzelnen Komponenten der photostrukturierbaren Paste erfolgte im wesentlichen wie bereits aus LT-97 161 bekannt. Dabei wurden zunächst die Bestandteile des organischen Binders mit dem Füllstoff beispielsweise in einem Drei-Walzen-Stuhl verrührt, um damit eine gleichmäßige Verteilung der Füllstoffteilchen im organischen Binder zu gewährleisten. Die auf diese Weise vorbereitete photostrukturierbare Paste wird dann in Form einer Funktionsschicht mit einer typischen Dicke von 500 nm bis 20 µm auf eine keramische Grünfolie mit Aluminiumoxid als keramischem Bestandteil aufgetragen.

Danach werden die derart mit der Funktionsschicht versehenen Grünfolien bei einer Temperatur von 80°C bis 100°C über eine Zeit von typischerweise 5 min bis 20 min getrocknet und schließlich mit einer Photomaske mit UV-Licht belichtet. Die Photomaske ist dazu beispielsweise in bekannter Weise in Form von mäanderförmigen Widerstandsleiterbahnen strukturiert.

Das UV-Licht bei der Belichtung weist bevorzugt eine Wellenlänge von 320 nm - 400 nm auf.

Nach dem Belichten der nicht mit Hilfe der Photomaske abgedeckten Bereiche der Funktionsschicht auf der keramischen Grünfolie erfolgte dann das Entwickeln der Funktionsschicht bzw. der diese bildende photostrukturierbaren Paste. Dazu wird beispielsweise ein Aerosol einer wäßrigen, 0,5%-igen Monoethanolaminlösung auf eine sich mit einer Geschwindigkeit von typischerweise 3000 U/min drehende Unterlage, auf der die belichteten keramischen Grünfolien angeordnet sind, aufgetropft. Dieses Verfahren wird allgemein als "spin-development" bezeichnet und ist in LT-97 161 näher erläutert.

Nach dem Entwickeln der photostrukturierbaren Paste werden schließlich die nicht belichteten Bereiche der Funktionsschicht mit Hilfe einer wasserlöslichen Basislösung wieder abgewaschen.

Die weitere Verarbeitung der keramischen Grünfolien mit der darauf befindlichen, entwickelten, photostrukturierten Funktionsschicht erfolgt dann weiter in der aus der Anmeldung DE 199 34 109.5 bekannten Weise. So werden die mit den strukturierten Funktionsschichten versehenen keramischen Grünfolien gegebenenfalls mit weiteren keramischen Grünfolien gestapelt, mit Durchkontaktierungen und elektrischen Anschlüssen versehen und schließlich bei Temperaturen von typischerweise 1050°C bis 1650°C beispielsweise zu einem Temperatursensor gesintert.

Die Figur 1 zeigt eine typische keramische Grünfolie als Ausgangskörper 10 auf der in der vorstehend erläuterten Weise eine platinhaltige, photostrukturierbare Funktionsschicht 12 mit einer typischen Dicke von 5 µm bis 20 µm aufgedruckt worden ist. Diese Funktionsschicht 12 wurde anschließend mit Hilfe einer Photomaske in der vorstehend erläuterten Weise photostrukturiert, so daß aus der Funkionsschicht 12 Strukturen 11 herausstrukturiert worden sind, die die Form von mäanderförmigen Leiterbahnen aufweisen. Diese Strukturen 11 haben eine typische laterale Ausdehnung von 15 µm. Der Ausgangskörper 10 mit der aufgebrachten strukturierten Funktionsschicht 12 wird nun gemäß Figur 2 mit weiteren keramischen Grünfolien zu einem grünen keramischen Stapelkörper zusammengesetzt und danach gesintert, so daß ein Temperaturfühler 5 entsteht, wie er prinzipiell bereits aus der Anmeldung DE 199 34 109.5 bekannt ist. In diesem Sinne ist Figur 1 lediglich ein Ausschnitt des Ausgangskörpers 10 gemäß Figur 2.

Die Figur 2 zeigt den zu erzeugenden Temperaturfühler 5 in Explosionsdarstellung, wobei zunächst der Ausgangskörper 10 in Form einer keramischen Grünfolie mit der photostrukturierten, platinhaltigen Funktionsschicht 12 versehen worden ist. Die Funktionsschicht 12 weist Strukturen 11 in Form von Mäandern als Widerstandsleiterbahnen auf, die auf der Oberfläche des Ausgangskörpers 10 zur elektrischen Kontaktierung zu Kontaktflächen 13 geführt sind. Auf der Unterseite des Ausgangskörpers 10 ist eine grüne keramische Trägerfolie 14 vorgesehen, die eine Ausnehmung 15 aufweist. Die Oberseite des Ausgangskörpers 10 wird von einer grünen keramischen Deckfolie 16 abgedeckt. Die Trägerfolie 14 und die Deckfolie 16 weisen bevorzugt die gleiche Zusammensetzung wie der Ausgangskörper 10 auf.

Hinsichtlich näherer Details zu der Funktion und konstruktiven Einzelheiten des Temperaturfühlers 5 sei auf die Anmeldung DE 199 34 109.5 verwiesen. Nach dem Zusammenfügen des mit der Funktionsschicht 12 versehenen Ausgangskörpers 10 mit der Trägerfolie 14 und der Deckfolie 16 wird der so entstandene grüne keramische Stapelkörper einer Temperaturbehandlung unterzogen, wobei die Polymermatrix der Grünfolien zumindest weitgehend thermisch zersetzt und/oder verdunstet wird, und wobei die keramischen Grünfolien zwischen 1050°C und 1650°C gesintert werden. Dadurch entsteht unter anderem aus dem Ausgangskörper 10 eine gebrannte keramische Folie mit Widerstandsleiterbahnen, die durch die Strukturen 11 gebildet sind.

## Patentansprüche

1. Keramischer Grünkörper, insbesondere keramische Grünfolie, mit einer zumindest bereichsweise aufgebrachten, platinhaltigen Funktionsschicht (12), **dadurch gekennzeichnet, dass** die Funktionsschicht (12) frei von Glasbestandteilen ist und ein Polymer mit Acryl- und Allylgruppen, ein organisches Disulfid und einen Inhibitor der thermischen Polymerisation enthält, so dass die Funktionsschicht unter Tageslichteinfall und in Gegenwart von Sauerstoff photostrukturierbar ist.

2. Keramischer Grünkörper nach Anspruch 1, **dadurch gekennzeichnet, daß** der Grünkörper einen grünen keramischen Ausgangskörper (10) mit in einer Polymermatrix eingebetteten Keramikpartikeln, insbesondere gegebenenfalls Yttrium-stabilisierte ZrO₂- und/oder Al₂O₃-Partikel, aufweist.

3. Keramischer Grünkörper nach Anspruch 1 oder 2, **dadurch gekennzeichnet, daß** die Funktionsschicht (12) eine Dicke von 500 nm bis 40 µm hat.

4. Keramischer Grünkörper nach mindestens einem der Ansprüche 1 bis 3, **dadurch gekennzeichnet, daß** die photostrukturierte Funktionsschicht (12) Strukturen (11) aufweist, deren laterale Ausdehnung in mindestens einer Dimension, insbesondere in der Breite, zumindest bereichsweise unter 50 µm liegt.

5. Keramischer Grünkörper nach Anspruch 4, **dadurch gekennzeichnet, daß** die laterale Ausdehnung der Strukturen (11) in der Breite zumindest bereichsweise zwischen 3 µm und 20 µm liegt.

6. Keramischer Grünkörper nach mindestens einem der vorangehenden Ansprüche, **dadurch gekennzeichnet, daß** in mindestens einer Dimension die Standardabweichung der lateralen Ausdehnung der Strukturen (11) der photostrukturierten Funktionsschicht (12) von einem vorgegebenen Sollwert unter 10 µm, insbesondere unter 5 µm, liegt.

7. Keramischer Grünkörper nach mindestens einem der vorangehenden Ansprüche, **dadurch gekennzeichnet, daß** die Strukturen (11) zumindest bereichsweise zickzackförmige oder mäanderförmige Leiterbahnen und/oder Widerstandsbahnen sind.

8. Keramischer Grünkörper nach mindestens einem der vorangehenden Ansprüche, **dadurch gekennzeichnet, daß** zwischen der photostrukturierten Funktionsschicht (12) und dem Ausgangskörper (10) mindestens eine Zwischenschicht, insbesondere eine Al₂O₃-basierte Schicht oder eine Al₂O₃-Schicht von 1 µm bis 20 µm Dicke, vorgesehen ist.

9. Grüner keramischer Stapelkörper mit mindestens einem keramischen Grünkörper nach mindestens einem der Ansprüche 1 bis 8.

10. Verfahren zur Herstellung eines keramischen Grünkörpers nach mindestens einem der Ansprüche 1 bis 8, mit den Verfahrensschritten: a.) Bereitstellen des grünen keramischen Ausgangskörpers (10), b.) zumindest bereichsweises Aufbringen, insbesondere Aufdrucken, einer platinhaltigen photostrukturierbaren Paste auf den Ausgangskörper (10) unter Tageslichteinfall und in Gegenwart vor Sauerstoff, c.) Photostrukturierung der aufgebrachten Paste.

11. Verfahren nach Anspruch 10, **dadurch gekennzeichnet, daß** die aufgebrachte Paste vor der Photostrukturierung zunächst getrocknet wird.

12. Verfahren nach Anspruch 10 oder 11, **dadurch gekennzeichnet, daß** die Photostrukturierung mit Hilfe einer Photomaske durch bereichsweises Belichten mit UV-Licht, nachfolgendes Entwickeln und abschließendes Entfernen unbelichteter Bereiche erfolgt.

13. Verfahren nach mindestens einem der Ansprüche 10 bis 12, **dadurch gekennzeichnet, daß** der mit der photostrukturierten Funktionsschicht (12) versehene keramische Grünkörper einer Temperaturbehandlung unterzogen wird, wobei die Polymermatrix des Grünkörpers zumindest weitgehend thermisch zersetzt und/oder verdunstet wird, und wobei der keramische Grünkörper mit der strukturierten Funktionsschicht (12) zwischen 1050°C und 1650°C gesintert wird.

## Claims

1. Ceramic green body, in particular ceramic green tape, having a platinum-containing functional layer (12) applied to it at least in regions, **characterized in that** the functional layer (12) is free of glass constituents and contains a polymer comprising acrylic and allyl groups, an organic disulphide and a thermal polymerization inhibitor, so that the functional layer can be photostructured under the incidence of daylight and in the presence of oxygen.

2. Ceramic green body according to Claim 1, **characterized in that** the green body has a green ceramic starting body (10) with ceramic particles, in particular optionally yttrium-stabilized ZrO₂ and/or Al₂O₃ particles, embedded in a polymer matrix.

3. Ceramic green body according to Claim 1 or 2, **characterized in that** the functional layer (12) has a thickness of from 500 nm to 40 µm.

4. Ceramic green body according to at least one of Claims 1 to 3, **characterized in that** the photostructured functional layer (12) has structures (11) whose lateral extent in at least one dimension, in particular in the width dimension, is less than 50 µm at least in regions.

5. Ceramic green body according to Claim 4, **characterized in that** the lateral extent of the structures (11) in the width is between 3 µm and 20 µm at least in regions.

6. Ceramic green body according to at least one of the preceding claims, **characterized in that** in at least one dimension the standard deviation of the lateral extent of the structures (11) of the photostructured functional layer (12) from a predetermined set value is less than 10 µm, in particular less than 5 µm.

7. Ceramic green body according to at least one of the preceding claims, **characterized in that** the structures (11), at least in regions, are zigzag or meandering conductor tracks and/or resistor tracks.

8. Ceramic green body according to at least one of the preceding claims, **characterized in that** at least one interlayer, in particular an Al₂O₃-based layer or an Al₂O₃ layer with a thickness of from 1 µm to 20 µm, is provided between the photostructured functional layer (12) and the starting body (10).

9. Green ceramic stacked body having at least one ceramic green body according to at least one of Claims 1 to 8.

10. Process for producing a ceramic green body according to at least one of Claims 1 to 8, comprising the process steps of: a.) providing the green ceramic starting body (10), b.) applying, in particular printing, a platinum-containing, photostructurable paste to the starting body (10), at least in regions, under incident daylight and in the presence of oxygen, c.) photostructuring the paste which has been applied.

11. Process according to Claim 10, **characterized in that** the paste which has been applied is dried before the photostructuring is carried out.

12. Process according to Claim 10 or 11, **characterized in that** the photostructuring is carried out with the aid of a photomask by exposure in regions with UV light, followed by developing and finally removal of unexposed regions.

13. Process according to at least one of Claims 10 to 12, **characterized in that** the ceramic green body which has been provided with the photostructured functional layer (12) is subjected to a heat treatment, in which the polymer matrix of the green body is at least substantially thermally decomposed and/or evaporated, and in which the ceramic green body with the structured functional layer (12) is sintered at between 1050°C and 1650°C.

## Revendications

1. Ebauche céramique crue, en particulier ébauche crue en feuille céramique, comportant une couche fonctionnelle contenant du platine, appliquée au moins par endroits (12),
**caractérisée en ce que**
la couche fonctionnelle (12) est exempte de constituants du verre et contient un polymère comportant des groupes acryliques et allyliques, un disulfure organique et un inhibiteur de polymérisation thermique, de telle sorte que la couche fonctionnelle soit photostructurable sous l'incidence de la lumière du jour et en présence d'oxygène.

2. Ebauche céramique crue selon la revendication 1,
**caractérisée en ce que**
cette ébauche comporte un corps initial céramique brut (10) avec des particules de céramique enrobées dans une matrice de polymère, en particulier des particules de ZrO₂ et/ou Al₂O₃, le cas échéant stabilisées avec de l'yttrium.

3. Ebauche céramique crue selon la revendication 1 ou 2,
**caractérisée en ce que**
la couche fonctionnelle (12) a une épaisseur de 500 nm à 40 µm.

4. Ebauche céramique crue selon au moins l'une quelconque des revendications 1 à 3,
**caractérisée en ce que**
la couche fonctionnelle photostructurée (12) comporte des structures (11) dont l'extension latérale est, dans au moins une dimension, en particulier en largeur, tout au moins par endroits, inférieure à 50 µm.

5. Ebauche céramique crue selon la revendication 4,
**caractérisée en ce que**
l'extension latérale des structures (11) en largeur, se trouve tout au moins par endroits, entre 3 µm et 20 µm.

6. Ebauche céramique crue selon au moins l'une quelconque des revendications précédentes,
**caractérisée en ce que**
dans au moins une dimension, l'écart-type de l'extension latérale des structures (11) de la couche fonctionnelle photostructurée (12) est inférieur, par rapport à une valeur théorique prédéterminée, à 10 µm, en particulier à 5 µm.

7. Ebauche céramique crue selon au moins l'une quelconque des revendications précédentes,
**caractérisée en ce que**
les structures (11) sont des pistes conductives et/ou des pistes résistives, tout au moins par endroits, en zig-zag ou en forme de méandres.

8. Ebauche céramique crue selon au moins l'une quelconque des revendications précédentes,
**caractérisée en ce qu'**
est prévu, entre la couche fonctionnelle photostructurée (12) et le corps initial (10), au moins une couche intermédiaire, en particulier une couche à base d' Al₂O₃ ou une couche d'Al₂O₃ de 1 µm à 20 µm d'épaisseur.

9. Corps empilé céramique cru comportant au moins une ébauche céramique selon au moins l'une quelconque des revendications 1 à 8.

10. Procédé de production d'une ébauche céramique crue selon au moins l'une quelconque des revendications 1 à 8, comportant les étapes suivantes : a) préparation du corps initial céramique brut (10), b) application, tout au moins par endroits, en particulier impression d'une pâte photostructurable contenant du platine sur le corps initial (10) sous incidence de la lumière du jour et en présence d'oxygène, c) photostructuration de la pâte appliquée.

11. Procédé selon la revendication 10,
**caractérisé en ce que**
la pâte appliquée est d'abord séchée avant la photostructuration.

12. Procédé selon la revendication 10 ou 11,
**caractérisé en ce que**
la photostructuration a lieu à l'aide d'un masque photo par exposition par endroits à la lumière UV, suivie d'un développement et enfin d'un enlèvement des parties non exposées.

13. Procédé selon au moins l'une quelconque des revendications 10 à 12,
**caractérisé en ce que**
l'ébauche céramique crue pourvue de la couche fonctionnelle photostructurée (12) est exposée à un traitement thermique, la matrice de polymère de l'ébauche étant tout au moins largement décomposée et/ou volatilisée thermiquement, et l'ébauche céramique avec la couche fonctionnelle structurée (12) étant frittée entre 1050 °C et 1650 °C.
